# EUROPEAN PATENT APPLICATION

(11) **EP 2 980 981 A1**
(43) Date of publication of application: **03.02.2016**
(21) Application number: 14275161.9
(22) Date of filing: 30.07.2014
(51) Int. Cl.: H02M 7/483, H02M 7/00

(54) **Improvements in or relating to electrical assemblies for voltage source sub-modules**

(71) Applicant: ALSTOM Technology Ltd, 5400 Baden (CH)
(72) Inventor: OUTRAM, John Lewis, Stone, Staffordshire ST15 8YD (GB); MELLOR, Andrew, Stoke on Trent, Staffordshire ST15 8GS (GB); PERRIER, Jerome, Newbold, Rugby CV21 1DE (GB)
(74) Representative: Potter Clarkson LLP

(57) **Abstract**

In the field of high voltage direct current (HVDC) power converters an electrical assembly (10; 100) for a voltage source sub-module (70; 150) comprises a first semiconductor device module (12) which includes a plurality of first semiconductor devices (14a, 14b, 14c). The electrical assembly (10; 100) also includes an energy storage device (34) which in turn includes a plurality of energy storage sections (36a, 36b, 36c) that are configured to control the magnitude of a current portion flowing through each first semiconductor device (14a, 14b, 14c). The energy storage sections (36a, 36b, 36c) are so configured by arranging each energy storage section (36a, 36b, 36c) in isolation from the or each other energy storage section (36a, 36b, 36c) to divide a current (I_{c}) flowing through the energy storage device (34) into a plurality of the said current portions (I₁, I₂, I₃) and thereby cause each current portion (I₁, I₂, I₃) to flow through a respective one of the plurality of energy storage sections (36a, 36b, 36c). The energy storage sections (36a, 36b, 36c) are still further so configured by connecting each energy storage section (36a, 36b, 36c) to a respective one of the plurality of first semiconductor devices (14a, 14b, 14c) whereby each first semiconductor device (14a, 14b, 14c) conducts the corresponding said current portion (I₁, I₂, I₃).

## Description

This invention relates to an electrical assembly for a voltage source sub-module which may form part of a high voltage direct current (HVDC) power converter, and to a voltage source sub-module including such an electrical assembly.

In power transmission networks alternating current (AC) power is typically converted to direct current (DC) power for transmission via overhead lines and/or under-sea cables. This conversion removes the need to compensate for the AC capacitive load effects imposed by the transmission line or cable and reduces the cost per kilometre of the lines and/or cables, and thus becomes cost-effective when power needs to be transmitted over a long distance.

HVDC power converters are used to convert between AC power and DC power. Semiconductor devices and energy storage devices are key components of HVDC power converters since they often work together within individual voltage source sub-modules to selectively provide individual voltages that can be combined to provide a stepped variable voltage source which enables the power converter to provide the aforementioned power transfer functionality.

According to a first aspect of the invention there is provided an electrical assembly for a voltage source sub-module comprising:

A first semiconductor device module including a plurality of first semiconductor devices; and
an energy storage device including a plurality of energy storage sections configured to control the magnitude of a current portion flowing through each first semiconductor device by arranging each energy storage section in isolation from the or each other energy storage section to divide a current flowing through the energy storage device into a plurality of the said current portions and thereby cause each current portion to flow through a respective one of the plurality of energy storage sections, and by connecting each energy storage section to a respective one of the plurality of first semiconductor devices whereby each first semiconductor device conducts the corresponding said current portion.

Including a plurality of isolated energy storage sections in the energy storage device, and thereby dividing the current flowing through the energy storage device into a plurality of current portions, desirably controls the relative magnitude of each current portion.

Meanwhile, connecting each energy storage section to a respective one of the plurality of first semiconductor devices, whereby each first semiconductor device conducts the corresponding current portion, allows the individual isolated energy storage sections to also influence the relative magnitude of current flowing through each first semiconductor device.

The ability to influence, i.e. control, the magnitude of current flowing through each first semiconductor device is advantageous because it can be used to improve the overall performance rating of the electrical assembly, e.g. by helping to ensure that each first semiconductor device is loaded to its full capacity.

A preferred electrical assembly additionally includes a second semiconductor device module having a plurality of second semiconductor devices, and the energy storage device includes a plurality of energy storage sections configured to selectively control the magnitude of a current portion flowing through each of the first semiconductor devices and through each of the second semiconductor devices by connecting each energy storage section to a respective one of the first semiconductor devices and a respective one of the second semiconductor devices whereby in a first mode each first semiconductor device conducts the corresponding said current portion and in a second mode each second semiconductor device conducts the corresponding said current portion.

The foregoing arrangement extends the ability to control current magnitude to the current flowing through each of a plurality of second semiconductor devices in a second semiconductor device module, and thereby helps to additionally ensure that each second semiconductor device is similarly loaded to its full capacity in order to improve the overall performance rating of a further electrical assembly.

Preferably the energy storage device includes a plurality of energy storage sections which have equal energy storage capacities.

Including equal capacity energy storage sections in the energy storage device promotes equal current sharing between the said sections, and thereby results in the current flowing through the energy storage device being divided into a plurality of current portions of substantially equal magnitude.

Such an arrangement, and the provision of a plurality of substantially equal current portions in particular, further assists in improving the overall performance rating of the electrical assembly by helping to ensure that each component therein, and each semiconductor device especially, is loaded to a similar, if not equal, extent.

Optionally each semiconductor device is or includes a switching element which has a collector terminal and an emitter terminal and each energy storage section is connected to the collector terminal of the corresponding semiconductor device.

Electrically connecting a given energy storage section to the collector terminal of the corresponding semiconductor device leaves the emitter terminals of the semiconductor devices free to be interconnected with one another by a single, unitary bus bar member. Such interconnection of the emitter terminals allows them to be held at substantially the same voltage potential in order to reduce the risk of a separate low-current control connection between the emitter terminals conducting a high current which fuses the control connection.

In a preferred embodiment of the invention each energy storage section is connected to a respective one of the plurality of semiconductor devices in the or each semiconductor device module by a discrete bus bar portion.

Connecting each energy storage section to a respective semiconductor device in the or each semiconductor device module by a discrete bus bar portion ensures that the respective connections are electrically isolated from one another so as to extend the influence of the isolated individual energy storage portions, in terms of their effect on the relative magnitude of the current portions flowing through each energy storage portion, to the relative magnitude of current flowing through each said semiconductor device.

Preferably one or more of the discrete bus bar portions is defined by physically separate but electrically connected bus bar sub-portions.

The inclusion of such bus bar sub-portions increases the configuration options for the corresponding bus bar portions, and so helps to achieve a compact and space-efficient electrical assembly.

Optionally the bus bar sub-portions of the or each bus bar portion are separated from at least one other bus bar portion by an insulating member.

Such separation of the bus bar sub-portions further increases the aforementioned range of configuration options, as well as adding strength to the electrical assembly.

The region of each bus bar portion connected to a corresponding semiconductor device may lie in the same first plane.

The region of each bus bar portion connected to a corresponding energy storage section may lie in the same second plane.

Optionally the first and second planes lie at a different orientation to one another.

Each of the foregoing features further helps to provide a compact and space-efficient electrical assembly which also has an improved overall performance rating compared to conventional electrical assemblies.

Preferably the plurality of bus bar portions are laminated with at least one other bus bar member.

Laminating the plurality of bus bar portions minimises the inductance between the respective bus bar portions, each of which defines an electrical path between a respective semiconductor device and a corresponding energy storage section.

In addition, laminating the plurality of bus bar portions with at least one other bus bar member helps the bus bar portions to form a support structure upon which one or more components of the electrical assembly such as, for example, one or more energy storage sections and/or a semiconductor device module can be mounted.

In addition, the or each bus bar member advantageously provides an accessible connection to another terminal of one or more of the semiconductor devices and the energy storage sections which is not otherwise employed to connect a given energy storage device to a respective one of the semiconductor devices.

The plurality of bus bar portions may be separated from at least one bus bar member by an insulation member.

The inclusion of one or more insulation members adds strength to the support structure formed by the bus bar portions and the or each bus bar member, as well as electrically isolating the bus bar portions from the said at least one bus bar member to define a plurality of discrete current conduction paths between respective components of the electrical assembly.

Optionally the plurality of bus bar portions are interconnected with one another by one or more resistive discharge elements which define a safety discharge path to earth.

The or each resistive discharge element can be configured to have a high-enough resistance not to affect the magnitude of current flowing through each semiconductor device, while at the same time having a resistance which is low enough to provide an earth-down facility, e.g. to allow maintenance to be carried out safely.

According to a second aspect of the invention there is provided a voltage source sub-module comprising:
an electrical assembly as described hereinabove having a first semiconductor device module including a plurality of first semiconductor devices, and an energy storage device including a plurality of energy storage sections configured to control the magnitude of a current portion flowing through each first semiconductor device by arranging each energy storage section in isolation from the or each other energy storage section to divide a current flowing through the energy storage device into a plurality of the said current portions and thereby cause each current portion to flow through a respective one of the plurality of energy storage sections, and by connecting a first terminal of each energy storage section to a first terminal of a respective one of the plurality of first semiconductor devices whereby each first semiconductor device conducts the corresponding said current portion; and
a third semiconductor device module including a plurality of third semiconductor devices,
a second terminal of each first semiconductor device being connected with a first terminal of each of the third semiconductor devices, and
a second terminal of each energy storage section being connected with a second terminal of each third semiconductor device.

The various first and third semiconductor devices and energy storage sections are interconnected in a manner which improves the overall performance rating of the voltage source sub-module by helping to ensure that certain components of the sub-module are loaded to their full capacity.

Preferably the second terminal of each first semiconductor device is connected with the first terminal of each of the third semiconductor devices by a first bus bar member and the second terminal of each energy storage section is connected with the second terminal of each third semiconductor device by a second bus bar member, the first and second bus bar members being isolated from one another.

Such an arrangement provides a compact interconnection structure which additionally has an improved overall performance rating compared to conventional voltage source sub-modules.

In a still further preferred embodiment of the invention the first and third semiconductor device modules are connected in parallel with the energy storage device in a half-bridge arrangement.

Such a configuration desirably defines a 2-quadrant unipolar voltage source sub-module that can provide zero or positive voltage and can conduct current in two directions.

Optionally the first bus bar member defines a first connection terminal of the voltage source sub-module, and the second bus bar member defines a second connection terminal of the voltage source sub-module.

Such an arrangement provides for the ready inclusion of the said half-bridge voltage source sub-module in a series-connected string of sub-modules.

A voltage source sub-module according to a further preferred embodiment of the invention includes:
an electrical assembly as described hereinabove; and
a fourth semiconductor device module including a plurality of fourth semiconductor devices,
and is arranged whereby
a first terminal of each fourth semiconductor device is connected with a second terminal of each of the second semiconductor devices, and
the second terminal of each energy storage section is additionally connected with a second terminal of each of the fourth semiconductor devices.

Such an arrangement extends the improvement in overall performance rating achieved by helping to ensure that certain components are loaded to their full capacity to other voltage source sub-module configurations.

The first terminal of each fourth semiconductor device may connected with the second terminal of each of the second semiconductor devices by a third bus bar member which is electrically isolated from each of the first and second bus bar members.

The inclusion of such a third bus bar member advantageously provides a single accessible connection to each of the second and fourth semiconductor devices.

Preferably the first, second, third and fourth semiconductor device modules are connected in parallel with the energy storage device in a full-bridge arrangement.

Such a configuration desirably defines a 4-quadrant unipolar voltage source sub-module that can provide zero, positive, or negative voltage and can conduct current in two directions.

Optionally the first bus bar member defines a first connection terminal of the voltage source sub-module and the third bus bar member defines a second connection terminal of the voltage source sub-module.

Such an arrangement provides for the ready inclusion of the said full-bridge voltage source sub-module in a series-connected string of sub-modules.

There now follows a brief description of preferred embodiments of the invention, by way of non-limiting example, with reference being made to the following figures in which:
Figure 1 (a) shows a schematic circuit diagram of an electrical assembly according to a first embodiment of the invention which in turn forms a part of a voltage source sub-module according to another embodiment of the invention that is also shown therein;
Figure 1 (b) shows a simplified circuit diagram of the voltage source sub-module shown in Figure 1 (a);
Figure 2 shows a perspective view of respective bus bar portions and bus bar members which form a part of the voltage source sub-module shown in Figure 1(a);
Figure 3 illustrates more equal current sharing between semiconductor devices in an electrical assembly according to an embodiment of the invention compared to semiconductor devices in a conventional electrical assembly;
Figure 4(a) shows a schematic circuit diagram of an electrical assembly according to a further embodiment of the invention which in turn forms a part of a voltage source sub-module according to yet another embodiment of the invention that is also shown therein;
Figure 4(b) shows a simplified circuit diagram of the voltage source sub-module shown in Figure 4(a); and
Figure 5 shows an exploded perspective view of respective bus bar portions and bus bar members which form a part of the voltage source sub-module shown in Figure 4(a).

A first electrical assembly for a voltage source sub-module according to an embodiment of the invention is designated generally by reference numeral 10.

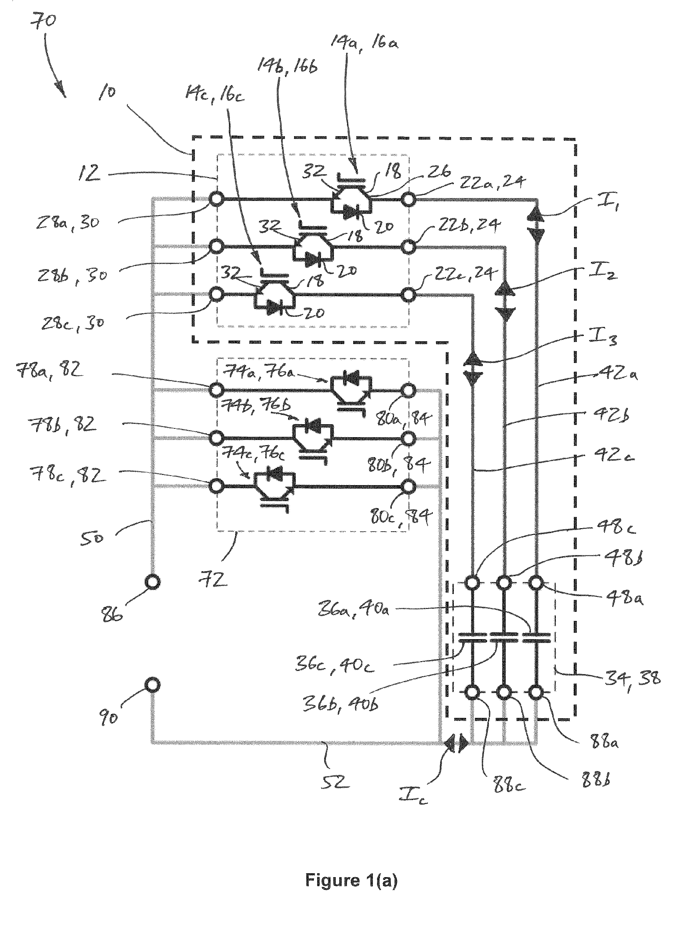

As shown in Figure 1(a) the first electrical assembly 10 includes a first semiconductor device module 12 which has three first semiconductor devices 14a, 14b, 14c in the form of first Insulated Gate Bipolar Transistor (IGBT) switching elements 16a, 16b, 16c. More particularly each first switching element 16a, 16b, 16c includes an IGBT 18 which is connected in parallel with an anti-parallel diode 20.

In other embodiments of the invention (not shown) the first semiconductor device module 12 may include more than or fewer than three first semiconductor devices 14a, 14b, 14c. One or more of the first switching elements 16a, 16b, 16c may be or may include a different semiconductor device such as a gate turn-off thyristor, a field effect transistor, an insulated gate commutated thyristor, an injection-enhanced gate transistor, an integrated gate commutated thyristor or any other self-commutated semiconductor device connected in series or in parallel.

Each first switching element 16a, 16b, 16c has a first terminal 22a, 22b, 22c in the form of a collector terminal 24 which is electrically connected to the collector 26 of the IGBT 18, and also a second terminal 28a, 28b, 28c in the form of an emitter terminal 30 which is electrically connected to the emitter 32 of the IGBT 18.

The electrical assembly 10 also has an energy storage device 34 that provides, i.e. includes, three energy storage sections 36a, 36b, 36c. Each energy storage section 36a, 36b, 36c is electrically isolated from the other energy storage sections 36a, 36b, 36c.

In the embodiment shown the energy storage device 34 is a single capacitor 38 which is split into three equal capacitor sections 40a, 40b, 40c, i.e. into three sections having equal energy storage capacities. Such an arrangement is physically convenient and more compact than separate capacitors. However, in other embodiments of the invention (not shown) the energy storage device may include a plurality of energy storage sections each of which is defined by a separate, individual capacitor.

In still further embodiments of the invention (not shown) the energy storage device 34 may include more than or fewer than three energy storage sections 36a, 36b, 36c, i.e. capacitor sections 40a, 40b, 40c. Preferably, however, the energy storage device 34 includes the same number of energy storage sections as there are first semiconductor devices 14a, 14b, 14c in the first semiconductor device module 12.

In addition, in other embodiments of the invention the single capacitor 38 of the energy storage device 34 may be replaced by a different energy storage device such as a fuel cell, a battery or any other energy storage device capable of storing and releasing its electrical energy to provide a voltage.

Each energy storage section 36a, 36b, 36c, i.e. each capacitor section 40a, 40b, 40c, is electrically connected to a single respective one, and only one, first semiconductor device 14a, 14b, 14c i.e. only one first switching element 16a, 16b, 16c.

More particularly, in the embodiment shown, each capacitor section 40a, 40b, 40c is connected to the first terminal 22a, 22b, 22c, i.e. the collector terminal 24, of a corresponding first switching element 16a, 16b, 16c. Each such electrical connection is provided by a discrete, i.e. physically separate and electrically isolated, bus bar portion 42a, 42b, 42c.

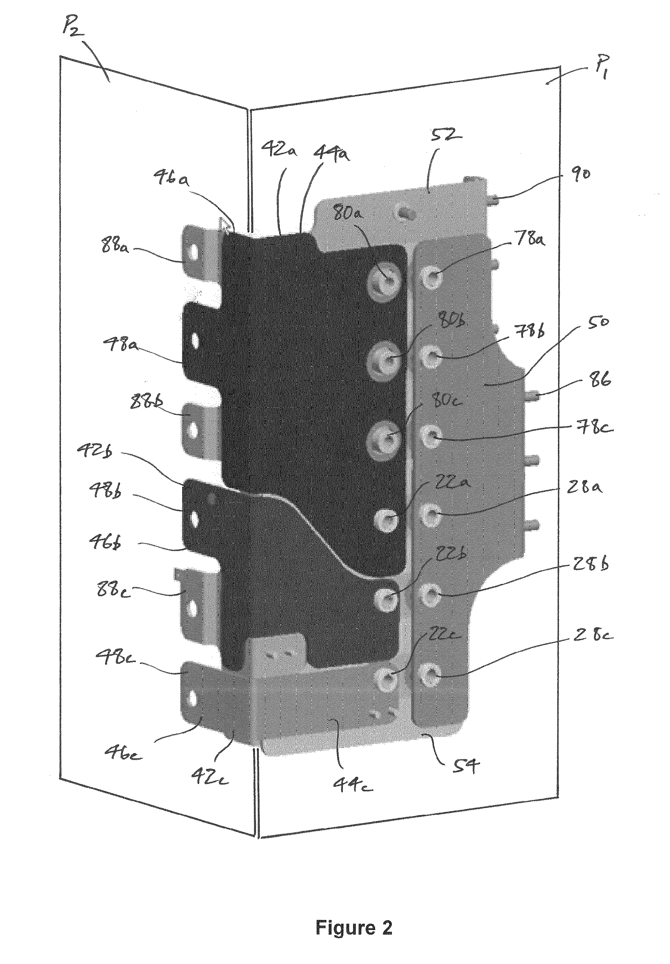

As shown in Figure 2, a first region 44a, 44b, 44c of each bus bar portion 42a, 42b, 42c which is connected to a corresponding first switching element 16a, 16b, 16c (not shown in Figure 2) all lie in the same first plane P₁ as one another. In the meantime a second region 46a, 46b, 46c of each bus bar portion 42a, 42b, 42c which is connected to a first terminal 48a, 48b, 48c of a corresponding capacitor section 40a, 40b, 40c (also not shown in Figure 2) all lie in the same second plane P₂ as one another. The first and second planes P₁, P₂ lie at a different orientation to another and more particularly, in the embodiment shown, lie at right angles to one another. In other embodiments of the invention the first and second planes P₁, P₂ may be arranged in a different manner relative to one another.

As further shown in Figure 2, the three bus bar portions 42a, 42b, 42c are laminated with first and second bus bar members 50, 52. The bus bar portions 42a, 42b, 42c overlie the second bus bar member 52 and are separated from it by a planar insulation member 54. Meanwhile each of the bus bar portions 42a, 42b, 42c lies coplanar with but spaced from the first bus bar member 50. In other embodiments of the invention (not shown) each of the bus bar portions 42a, 42b, 42c may instead partially overlap the first bus bar member 50, with the overlying portions being spaced from one another by an insulating member.

In any event, the bus bar portions 42a, 42b, 42c and first and second bus bar members 50, 52 are held in the aforementioned configuration by an adhesive, although other connection arrangements are also possible.

The bus bar portions 42a, 42b, 42c are interconnected with one another by respective resistive discharge elements (not shown) which define a safety discharge path to earth. In other embodiments of the invention the bus bar portions 42a, 42b, 42c may be interconnected with one another by a single resistive discharge element.

Further details of the configuration of the bus bar portions 42a, 42b, 42c and bus bar members 50, 52 are set out below in connection with details of a first voltage source sub-module 70 according to another embodiment of the invention.

In use the respective capacitor sections 40a, 40b, 40c control the magnitude of a current portion flowing through each first semiconductor device 14a, 14b, 14c, i.e. each first switching element 16a, 16b, 16c.

More particularly the respective capacitor sections 40a, 40b, 40c divide the current I_{c} flowing through the capacitor 38 into first, second and third equal current portions I₁, I₂, I₃, each of which flows through a corresponding respective capacitor section 40a, 40b, 40c. As such the current I_{c} flowing through the capacitor 38 is shared essentially equally between the capacitor sections 40a, 40b, 40c.

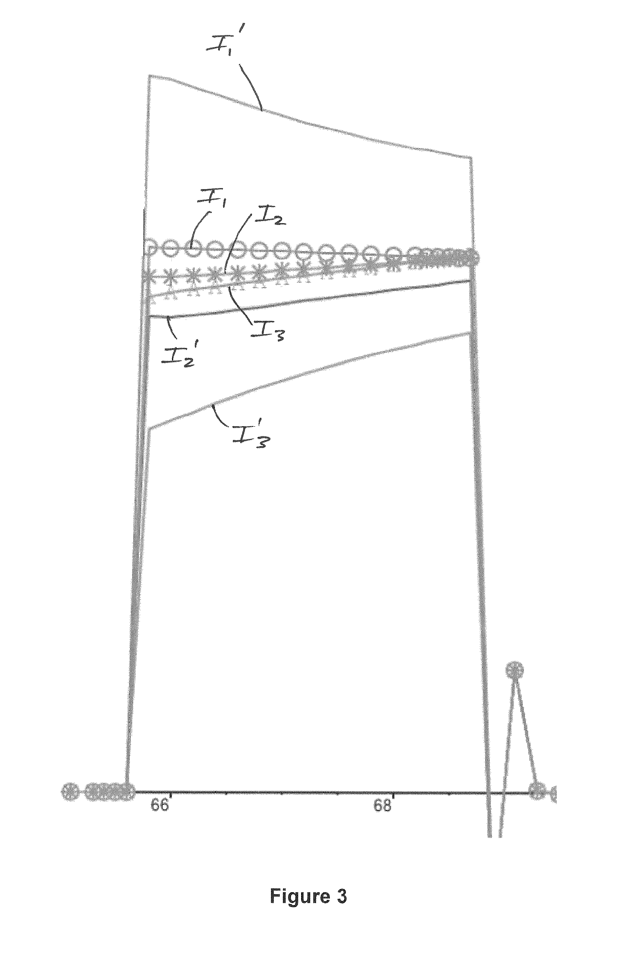

As a result of the foregoing, as shown in Figure 3, each first semiconductor device 14a, 14b, 14c, i.e. each first switching element 16a, 16b, 16c, conducts the same essentially equal current portion I₁, I₂, I₃ as the corresponding capacitor section 40a, 40b, 40c. This helps to ensure that each first switching element 16a, 16b, 16c is loaded equally and to its full capacity, and so provides the electrical assembly 10 of the invention with a higher overall performance rating than prior art assemblies in which the switching elements 16a, 16b, 16c are not so loaded and instead conduct current portions I'₁, I'₂, I'₃ of differing magnitudes (as also illustrated in Figure 3).

In the meantime, the resistive discharge elements which interconnect the bus bar portions 42a 42b, 42c have a high-enough resistance to not affect the equal sharing of current I₁, I₂, I₃ flowing through each first switching element 16a, 16b, 16c, while at the same time have a resistance which is low enough to selectively provide an earth-down facility, i.e. to selectively permit a discharge to earth of the current portion I₁, I₂, I₃ flowing through the respective bus bar portion 42a, 42b, 42c in order to allow, e.g. maintenance work to be carried out safely.

A first voltage source sub-module 70 according to another embodiment of the invention is also illustrated schematically in Figure 1 (a).

The first voltage source sub-module 70 includes the first electrical assembly 10 described hereinabove.

In addition the first sub-module 70 includes a third semiconductor device module 72 that has three third semiconductor devices 74a, 74b, 74c, i.e. the same number as in the first semiconductor device module 12. Each third semiconductor device 74a, 74b, 74c is a third switching element 76a, 76b, 76c that is identical to the first switching elements 16a, 16b, 16c described above in connection with the first semiconductor device module 12. As such each third switching element 76a, 76b, 76c includes also corresponding first and second terminals 78a, 78b, 78c, 80a, 80b, 80c which form collector and emitter terminals 82, 84, respectively.

As with the first semiconductor device module 12, in other embodiments of the invention one or more of the third switching elements 76a, 76b, 76c may be or may include a different semiconductor device such as a gate turn-off thyristor, a field effect transistor, an insulated gate commutated thyristor, an injection-enhanced gate transistor, an integrated gate commutated thyristor or any other self-commutated semiconductor device connected in series or in parallel.

As well as the various interconnections within the first electrical assembly 10 described above, the second terminal 28a, 28b, 28c of each first switching element 16a, 16b, 16c is connected with the first terminal 78a, 78b, 78c of a corresponding third switching element 76a, 76b, 76c to define a first connection terminal 86 of the voltage source sub-module 70. More particularly the aforementioned connection is provided by the first bus bar member 50 mentioned above.

In the meantime a second terminal 88a, 88b, 88c of each capacitor section 40a, 40b, 40c is connected with the second terminal 80a, 80b, 80c of each third switching element 76a, 76b, 76c to define a second connection terminal 90 of the first voltage source sub-module 70, with such interconnection being provided by the second bus bar member 52 described hereinabove.

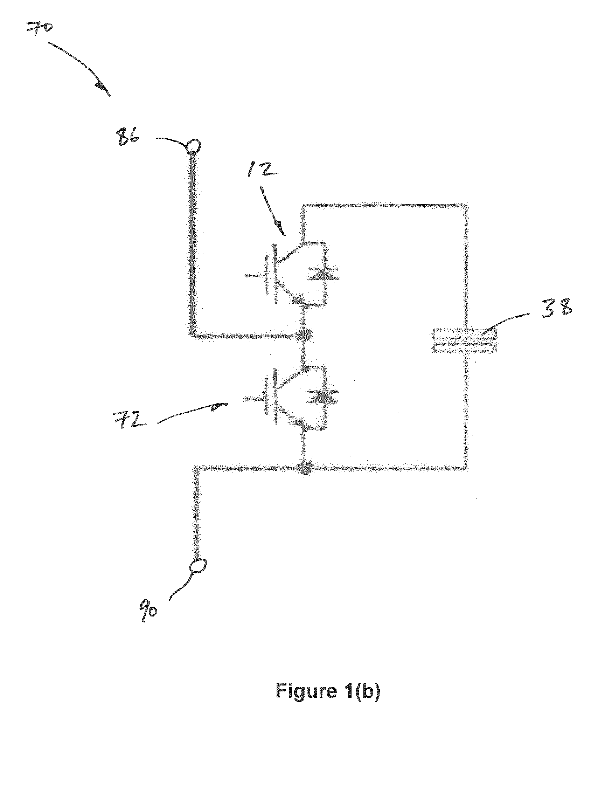

The first and third semiconductor device modules 12, 72 are connected in parallel with the energy storage device 34, i.e. the capacitor 38, in a half bridge arrangement, as shown schematically in Figure 1(b).

In use the first voltage source sub-module 70 selectively provides zero or positive voltage and conducts current in first and second directions I_{C} between the first and second connection terminals 86, 90. The current I_{C} is again shared essentially equally between the capacitor sections 40a, 40b, 40c such that each first switching element 16a, 16b, 16c, similarly conducts the same essentially equal current portion I₁, I₂, b as the corresponding capacitor section 40a, 40b, 40c.

At the same time, interconnecting the emitter terminals 30 of the first switching elements 16a, 16b 16c via a first bus bar member 50 allows the emitter 32 of the IGBT 18 in each first switching element 16a, 16b, 16c to be held at substantially the same voltage potential and thereby reduces the risk of a low-current control connection (not shown) between the emitter terminals conducting a high current which fuses the control connection.

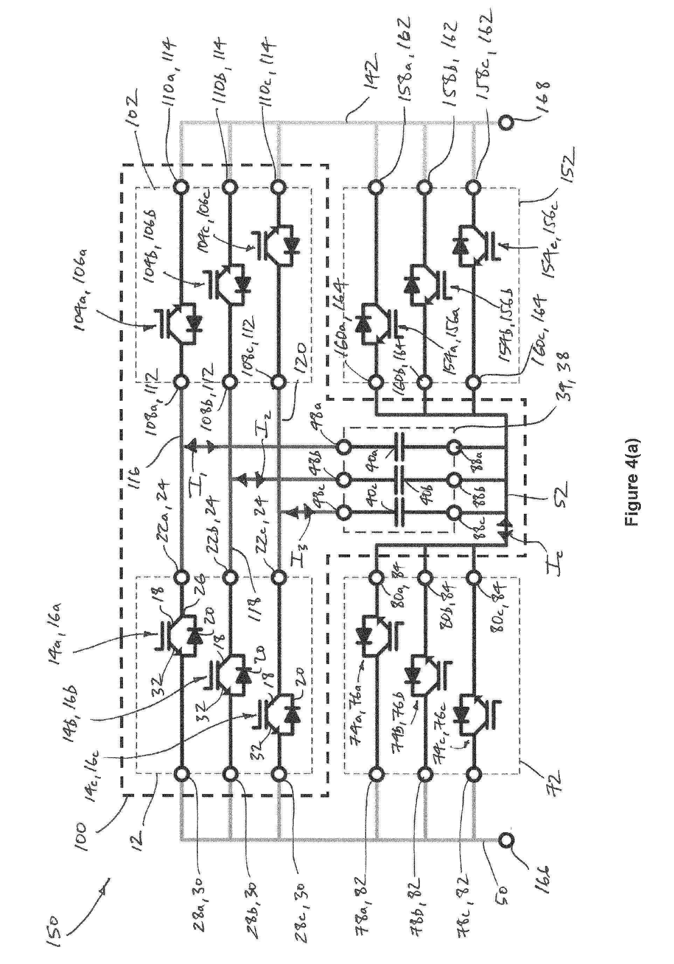

A second electrical assembly for a voltage source sub-module according to another embodiment of the invention is designated generally by reference numeral 100, as shown in Figure 4(a).

The second electrical assembly 100 shares a number of features with the first electrical assembly 10 and these similar features share the same reference numerals.

The second electrical assembly 100 differs from the first electrical assembly 10 in that it additionally includes a second semiconductor device module 102 which has three second semiconductor devices 104a, 104b, 104c, i.e. the same number as in the first semiconductor device module 12. Each second semiconductor device 104a, 104b, 104c is a third switching element 106a, 106b, 106c that is identical to the first and third switching elements 16a, 16b, 16c, 76a, 76b, 76c described hereinabove.

As such each second switching element 106a, 106b, 106c includes also corresponding first and second terminals 108a, 108b, 108c, 110a, 110b, 110c which form collector and emitter terminals 112, 114, respectively.

As with the first and third semiconductor device modules 12, 72 in other embodiments of the invention one or more of the second switching elements 106a, 106b, 106c may be or may include a different semiconductor device such as a gate turn-off thyristor, a field effect transistor, an insulated gate commutated thyristor, an injection-enhanced gate transistor, an integrated gate commutated thyristor or any other self-commutated semiconductor device connected in series or in parallel.

The second electrically assembly 100 similarly includes an energy storage device 34 that provides three energy storage sections 36a, 36b, 36c by way of a single capacitor 38 that is split into three equal capacitor sections 40a, 40b, 40c, i.e. into three sections having equal energy storage capacities. Other embodiments of the invention (not shown) may however include an energy storage device which has a plurality of energy storage sections that are defined by separate, individual capacitors.

Each energy storage section 36a, 36b, 36c, i.e. each capacitor section 40a, 40b, 40c, is electrically connected to a single respective one, and only one, first semiconductor device 14a, 14b, 14c i.e. only one first switching element 16a, 16b, 16c and also to a single respective one, and only one, second semiconductor device 104a, 104b, 104c, i.e. only one second switching element 106a, 106b, 106c.

More particularly, in the embodiment shown, each capacitor section 40a, 40b, 40c is connected to the first terminal 22a, 22b, 22c, i.e. the collector terminal 24, of a corresponding first switching element 16a, 16b, 16c and to the first terminal 108a, 108b, 108c, i.e. the collector terminal 112, of a corresponding second switching element 106a, 106b, 106c. Each such electrical connection is provided by a discrete, i.e. physically separate and electrically isolated, corresponding first, second or third bus bar portion 116, 118, 120.

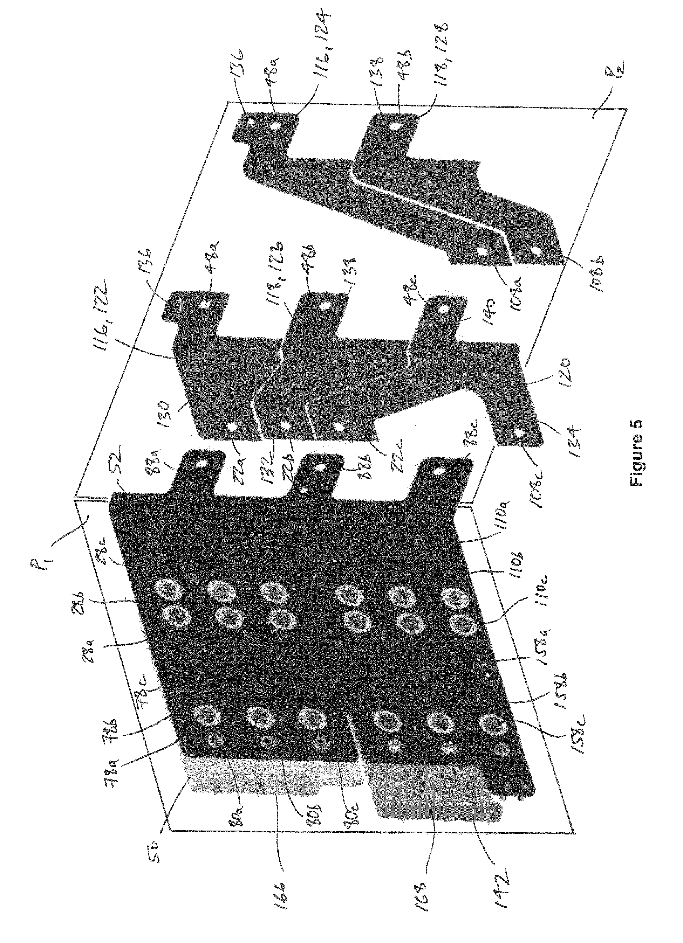

As shown in Figure 5, the first bus bar portion 116 is defined by physically separate but electrically connected first and second bus bar sub-portions 122, 124, with the first bus bar sub-portion 122 being connected to the first terminal 22a of the corresponding first switching element 16a, and the second bus bar sub-portion being connected to the first terminal 108a of the corresponding second switching element 106a. The first and second bus bar sub-portions 122, 124 are electrically connected to one another via the first terminal 48a of the corresponding capacitor section 40a.

Meanwhile the second bus bar portion 118 is similarly defined by physically separate but electrically connected third and fourth bus bar sub-portions 126, 128. The third bus bar sub-portion 126 is connected to the first terminal 22b of the corresponding first switching element 16b and the fourth bus bar sub-portion 128 is connected to the first terminal 108b of the corresponding second switching element 106b. In addition the third and fourth bus bar sub-portions 126, 128 are electrically connected to one another via the first terminal 48b of the corresponding capacitor section 40b.

Each of the second and fourth bus bar sub-portions 124, 128 is separated from the first and third bus bar sub-portions 122, 126, and the third bus bar portion 120, by an insulating member (not shown).

As also shown in Figure 5, a first region 130 of the first bus bar portion 116, i.e. a first region 130 of each of the first and second bus bar sub-portions 122, 124 which make up the first bus bar portion 116, lies in a first plane P₁. Similarly, a first region 132 of the second bus bar portion 118, i.e. a first region 132 of each of the third and fourth bus bar sub-portions 126, 128 that make up the second bus bar portion 118, lies in the same first plane P₁. Likewise, a first region 134 of the third bus bar portion 120 also lies in the same first plane P₁.

In the meantime a second region 136 of the first bus bar portion 116, i.e. a second region 136 of each of the first and second bus bar sub-portions 122, 124 which make up the first bus bar portion 116, lies in a second plane P₂. A second region 138 of the second bus bar portion 118, i.e. a second region 138 of each of the third and fourth bus bar sub-portions 126, 128 that make up the second bus bar portion 118, lies in the same second plane P₂. A second region 140 of the third bus bar portion 120 also lies in the same second plane P₂.

The first and second planes P₁, P₂ lie at a different orientation to one another and more particularly, in the embodiment shown, lie at right angles to one another. In other embodiments of the invention the first and second planes P₁, P₂ may be arranged in a different manner relative to one another. In still further embodiments of the invention, different arrangements of bus bar portions and bus bar sub-portions are also possible.

As further shown in Figure 5, the first, second and third bus bar portions 116, 118, 120 (and more particularly the first bus bar sub-portion 122 of the first bus bar portion 116, and the third bus bar sub-portion 126 of the second bus bar portion 118) are laminated with the second bus bar member 52. The first, second and third bus bar portions 116, 118, 120 overlie the second bus bar member 52 and are separated from it by a planar insulation member (not shown). Meanwhile the second bus bar member 52 is laminated with a first bus bar member 50 and a third bus bar member 142, both of which lie coplanar but spaced from one another. Each of the first and third bus bar members 50, 142 are similarly separated from the second bus bar member 52 by respective insulation members (not shown).

The bus bar portions 116, 118, 120 and bus bar members 50, 52, 142 are held in the aforementioned configuration by an adhesive, although other connection arrangements are also possible.

In addition to the foregoing the first, second and third bus bar portions 116, 118, 120 are interconnected with one another by respective resistive discharge elements (not shown) which define a safety discharge path to earth. In other embodiments of the invention the first, second and third bus bar portions 116, 118, 120 may be interconnected with one another by a single resistive discharge element.

Further details of the configuration of the first, second and third bus bar portions 116, 118, 120 and the bus bar members 50, 52, 142 are set out below in connection with details of a second voltage source sub-module 150 according to a yet further embodiment of the invention.

In use the respective capacitor sections 40a, 40b, 40c of the second electrical assembly 100 selectively control the magnitude of a current portion flowing through each first semiconductor device 14a, 14b, 14c, i.e. each first switching element 16a, 16b, 16c, and through each second semiconductor device 104a, 104b, 104c, i.e. each second switching element 106a, 106b, 106c.

More particularly the respective capacitor sections 40a, 40b, 40c again divide the current I_{C} flowing through the capacitor 38 into first, second and third equal current portions I₁, I₂, I₃, each of which flows through a corresponding respective capacitor section 40a, 40b, 40c. As such the current I_{C} flowing through the capacitor 38 is, in an identical manner to in the first electrical assembly 10, shared essentially equally between the capacitor sections 40a, 40b, 40c.

As a result of the foregoing in a first mode (as is determined by control of the first and second semiconductor device modules 12, 102, and more particularly by switching off the second semiconductor device module 102 and thereby preventing the flow of current through each of the second semiconductor devices 104a, 104b, 104c therein), each first semiconductor device 14a, 14b, 14c, i.e. each first switching element 16a, 16b, 16c, conducts the same essentially equal current portion I₁, I₂, I₃ as the corresponding capacitor section 40a, 40b, 40c.

In the meantime, in a second mode (as is again determined by control of the first and second semiconductor device modules 12, 102, and more particularly by switching off the first semiconductor device module 12 and thereby preventing the flow of current through each of the first semiconductor devices 14a, 14b, 14c), each second semiconductor device 104a, 104b, 104c, i.e. each second switching element 106a, 106b, 106c, conducts the same essentially equal current portion I₁, I₂, I₃ as the corresponding capacitor section 40a, 40b, 40c.

This helps to ensure that in each mode the corresponding first switching elements 16a, 16b, 16c or second switching elements 106a, 106b, 106c are each loaded equally and to their full capacity, so as to provide the second electrical assembly 100 of the invention with a higher overall performance rating than prior art assemblies in which the first switching elements 16a, 16b, 16c and the second switching elements 106a, 106b, 106c are not so loaded and instead conduct current portions of differing magnitudes.

Meanwhile the resistive discharge elements which interconnect the first, second and third bus bar portions 116, 118, 120 have a high-enough resistance to not affect the equal sharing of current I₁, I₂, I₃ flowing selectively through each first switching element 16a, 16b, 16c and each second switching element 106a, 106b, 106c, while at the same time have a resistance which is low enough to selectively provide an earth-down facility, i.e. to selectively permit a discharge to earth of the current portion I₁, I₂, I₃ flowing through the respective bus bar portion 116, 118, 120 in order to allow, e.g. maintenance work to be carried out safely.

A second voltage source sub-module 150 according to another embodiment of the invention is also illustrated schematically in Figure 4(a).

The second voltage source sub-module 150 is similar to the first voltage source sub-module 70 and like features share the same reference numerals.

The second voltage source sub-module 150 differs, however, from the first voltage source sub-module 70 in that it includes the second electrical assembly 100 described hereinabove.

In addition the voltage source second sub-module 150 includes a fourth semiconductor device module 152 that has three fourth semiconductor devices 154a, 154b, 154c, i.e. the same number as in the first semiconductor device module 12. Each fourth semiconductor device 154a, 154b, 154c is a fourth switching element 156a, 156b, 156c that is identical to each of the first, second and third switching elements 16a, 16b, 16c, 106a, 106b, 106c, 76a, 76b, 76c described above. As such each fourth switching element 156a, 156b, 156c includes also corresponding first and second terminals 158a, 158b, 158c, 160a, 160b, 160c which form collector and emitter terminals 162, 164, respectively.

As with each of the first, second and third semiconductor device modules 12, 102, 72 in other embodiments of the invention, one or more of the fourth switching elements 156a, 156b, 156c may be or may include a different semiconductor device such as a gate turn-off thyristor, a field effect transistor, an insulated gate commutated thyristor, an injection-enhanced gate transistor, an integrated gate commutated thyristor or any other self-commutated semiconductor device connected in series or in parallel.

As well as the various interconnections within the second electrical assembly 100 described above, the first terminal 158a, 158b, 158c of each fourth switching element 156a, 156b, 156c is connected with the second terminal 110a, 110b, 110c of each of the second switching elements 106a, 106b, 106c by the third bus bar member 142. The third bus bar member 142 is, in turn, electrically isolated from each of the first and second bus bar members 50, 52.

In addition to the foregoing the second terminal 88a, 88b, 88c of each energy storage section 36a, 36b, 36c, i.e. each capacitor section 40a, 40b, 40c, is additionally connected with the second terminal 160a, 160b, 160c of each of the fourth switching elements 156a, 156b, 156c, with the second bus bar member 52 providing the said additional connections.

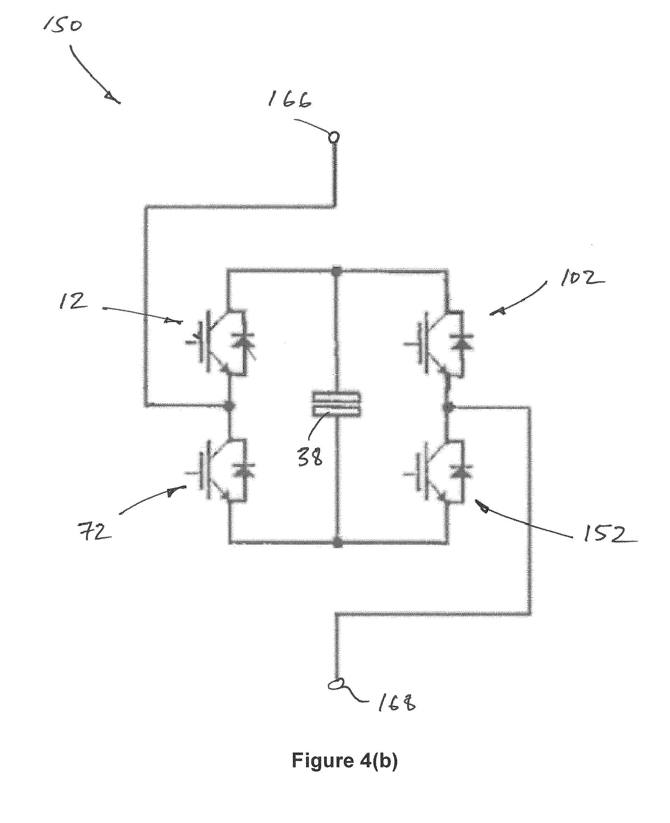

The first, second, third and fourth semiconductor device modules 12, 102, 72, 152 are connected in parallel with the energy storage device 34, i.e. the capacitor 38, in a full-bridge arrangement, as shown schematically in Figure 4(b).

The first bus bar member 50 again defines a first connection terminal 166 of the second voltage source sub-module 150 while the third bus bar member 142 defines a second connection terminal 168 of the second sub-module 150.

In use the second voltage source sub-module 150 selectively provides zero, positive or negative voltage and conducts current in first and second directions I_{C} between the first and second connection terminals 166, 168. During such operation the current I_{C} is again shared essentially equally between the capacitor sections 40a, 40b, 40c such that in a first mode each first switching element 16a, 16b, 16c, similarly conducts the same essentially equal current portion I₁, I₂, I₃ as the corresponding capacitor section 40a, 40b, 40c, and in a second mode each second switching element 106a, 106b, 106c similarly conducts the same essentially equal current portion I₁, I₂, is as the corresponding capacitor section 40a, 40b, 40c.

At the same time, interconnecting the emitter terminals 30 of the second switching elements 106a, 106b 106c via a third bus bar member 142 allows the emitter 32 of the IGBT 18 in each second switching element 106a, 106b, 106c to be held at substantially the same voltage potential and thereby reduces the risk of a low-current control connection (not shown) between the emitter terminals conducting a high current which fuses the control connection.

## Claims

1. An electrical assembly for a voltage source sub-module comprising:
a first semiconductor device module including a plurality of first semiconductor devices; and
an energy storage device including a plurality of energy storage sections configured to control the magnitude of a current portion flowing through each first semiconductor device by arranging each energy storage section in isolation from the or each other energy storage section to divide a current flowing through the energy storage device into a plurality of the said current portions and thereby cause each current portion to flow through a respective one of the plurality of energy storage sections, and by connecting each energy storage section to a respective one of the plurality of first semiconductor devices whereby each first semiconductor device conducts the corresponding said current portion.

2. An electrical assembly according to Claim 1 additionally including a second semiconductor device module having a plurality of second semiconductor devices, and wherein the energy storage device includes a plurality of energy storage sections configured to selectively control the magnitude of a current portion flowing through each of the first semiconductor devices and through each of the second semiconductor devices by connecting each energy storage section to a respective one of the first semiconductor devices and a respective one of the second semiconductor devices whereby in a first mode each first semiconductor device conducts the corresponding said current portion and in a second mode each second semiconductor device conducts the corresponding said current portion.

3. An electrical assembly according to Claim 1 or Claim 2 wherein the energy storage device includes a plurality of energy storage sections which have equal energy storage capacities.

4. An electrical assembly according to any preceding claim wherein each semiconductor device is or includes a switching element which has a collector terminal and an emitter terminal and each energy storage section is connected to the collector terminal of the corresponding semiconductor device.

5. An electrical assembly according to any preceding claim wherein each energy storage section is connected to a respective one of the plurality of semiconductor devices in the or each semiconductor device module by a discrete bus bar portion.

6. An electrical assembly according to Claim 5 when dependent on Claim 2 wherein one or more of the discrete bus bar portions is defined by physically separate but electrically connected bus bar sub-portions.

7. An electrical assembly according to Claim 6 wherein the bus bar sub-portions of the or each bus bar portion are separated from at least one other bus bar portion by an insulating member.

8. An electrical assembly according to any of Claims 5 to 7 wherein the region of each bus bar portion connected to a corresponding semiconductor device lies in the same first plane.

9. An electrical assembly according to any of Claims 5 to 8 wherein the region of each bus bar portion connected to a corresponding energy storage section lies in the same second plane.

10. An electrical assembly according to Claim 9 when dependent on Claim 8 wherein the first and second planes lie at a different orientation to one another.

11. An electrical assembly according to any of Claims 5 to 10 wherein the plurality of bus bar portions are laminated with at least one other bus bar member.

12. An electrical assembly according to Claim 11 wherein the plurality of bus bar portions are separated from at least one bus bar member by an insulation member.

13. An electrical assembly according to any of Claims 5 to 12 wherein the plurality of bus bar portions are interconnected with one another by one or more resistive discharge elements which define a safety discharge path to earth.

14. A voltage source sub-module comprising:
an electrical assembly according to any preceding claim having a first semiconductor device module including a plurality of first semiconductor devices, and an energy storage device including a plurality of energy storage sections configured to control the magnitude of a current portion flowing through each first semiconductor device by arranging each energy storage section in isolation from the or each other energy storage section to divide a current flowing through the energy storage device into a plurality of the said current portions and thereby cause each current portion to flow through a respective one of the plurality of energy storage sections, and by connecting a first terminal of each energy storage section to a first terminal of a respective one of the plurality of first semiconductor devices whereby each first semiconductor device conducts the corresponding said current portion; and
a third semiconductor device module including a plurality of third semiconductor devices,
a second terminal of each first semiconductor device being connected with a first terminal of each of the third semiconductor devices, and
a second terminal of each energy storage section being connected with a second terminal of each third semiconductor device.

15. A voltage source sub-module according to Claim 14 wherein the second terminal of each first semiconductor device is connected with the first terminal of each of the third semiconductor devices by a first bus bar member and the second terminal of each energy storage section is connected with the second terminal of each third semiconductor device by a second bus bar member, the first and second bus bar members being isolated from one another.

16. A voltage source sub-module according to Claim 14 or Claim 15 wherein the first and third semiconductor device modules are connected in parallel with the energy storage device in a half-bridge arrangement.

17. A voltage source sub-module according to Claim 16 when dependent on Claim 15 wherein the first bus bar member defines a first connection terminal of the voltage source sub-module, and wherein the second bus bar member defines a second connection terminal of the voltage source sub-module.

18. A voltage source sub-module according to Claim 14 or Claim 15 including:
an electrical assembly according to Claim 2 or any of Claims 3 to 13 when dependent on Claim 2; and
a fourth semiconductor device module including a plurality of fourth semiconductor devices,
wherein
a first terminal of each fourth semiconductor device is connected with a second terminal of each of the second semiconductor devices, and
the second terminal of each energy storage section is additionally connected with a second terminal of each of the fourth semiconductor devices.

19. A voltage source sub-module according to Claim 18 when dependent on Claim 15 wherein the first terminal of each fourth semiconductor device is connected with the second terminal of each of the second semiconductor devices by a third bus bar member electrically isolated from each of the first and second bus bar members.

20. A voltage source sub-module according to Claim 18 or Claim 19 wherein the first, second, third and fourth semiconductor device modules are connected in parallel with the energy storage device in a full-bridge arrangement.

21. A voltage source sub-module according to Claim 20 when dependent on Claim 19 wherein the first bus bar member defines a first connection terminal of the voltage source sub-module and the third bus bar member defines a second connection terminal of the voltage source sub-module.
